# EUROPÄISCHE PATENTSCHRIFT

(11) **EP 2 174 413 B1**
(45) Veröffentlichungstag und Bekanntmachung des Hinweises auf die Patenterteilung: **16.02.2011**
(21) Anmeldenummer: 08749035.5
(22) Anmeldetag: 21.04.2008
(51) Int. Cl.: H03D 1/00

(54) **VERFAHREN UND VORRICHTUNG ZUR DETEKTION VON SIMULTANER DOPPELAUSSENDUNG VON AM-SIGNALEN**
METHOD AND DEVICE FOR THE DETECTION OF SIMULTANEOUS DUAL TRANSMISSION OF AM SIGNALS
PROCÉDÉ ET DISPOSITIF DE DÉTECTION DE DOUBLE TRANSMISSION SIMULTANÉE DE SIGNAUX AM

(30) Priorität: 09.05.2007 DE 102007021768; 07.08.2007 DE 102007037105
(43) Veröffentlichungstag der Anmeldung: 14.04.2010
(73) Patentinhaber: Rohde & Schwarz GmbH & Co. KG, 81671 München (DE)
(72) Erfinder: LIPP, Friedrich, 81737 München (DE)
(74) Vertreter: Körfer, Thomas
(86) Internationale Anmeldenummer: PCT/EP2008/003201
(87) Internationale Veröffentlichungsnummer: WO 2008/138453

(56) Entgegenhaltungen:
- EP-A- 0 378 719
- WO-A-2004/015853
- US-A- 5 940 748
- US-B1- 6 977 978

## Beschreibung

Die Erfindung betrifft ein Verfahren und eine Vorrichtung zur Detektion von simultaner Mehrfachaussendung in Kommunikationssystemen mit amplitudenmodulierten Signalen, insbesondere in Flugfunkanlagen in der Flugsicherung (ATC).

Zum Stand der Technik sei auf die US 6,823,025 B2 verwiesen, aus der ein Detektor für Amplitudenmodulation bekannt ist. Die Detektion einer Doppelaussendung ist damit jedoch nicht möglich. Das Dokument US-6977978 gehört auch zum Stand der Technik.

Durch das ständig anwachsende Verkehrsaufkommen in der zivilen Luftfahrt steigt die Gefahr von simultanen Doppelaussendungen am selben Kanal. Speziell im Bereich stark frequentierter Flugplätze kann es passieren, dass zwei Piloten zugleich mit dem Fluglotsen Kontakt aufnehmen, ohne dass Fluglotse und Piloten diese gefährliche Situation bemerken. Der Fluglotse hört nur das stärkere Signal und quittiert den Funkspruch. Der ungehörte Pilot hingegen denkt, dass die Antwort des Fluglotsen ihm gegolten hat.

Das häufig verwendete Modulationsverfahren AM-DSB (Amplitudenmodulation - Zwei Seitenbänder) verhält sich linear gegenüber Mehrempfang, wonach das schwächere Empfangssignal (in der Folge Sekundärsignal genannt) proportional leiser demoduliert wird. Wegen des begrenzten Störabstandes und der Nebengeräusche im Cockpit kann ein um 20 bis 30dB schwächeres Signal kaum erkannt werden.

Solange die Quarzgenauigkeit der Flugfunkgeräte den ursprünglich von der ICAO (International Civil Aviation Organization) spezifizierten Bereich von +/-5ppm tatsächlich ausschöpft, entsteht ein gut hörbarer Pfeifton mit der Differenzfrequenz der beiden Flugfunkgeräte. Heutige Flugfunkgeräte mit modernen Referenzoszillatoren sind sehr frequenzgenau mit Ablagen von weniger als 1ppm, wodurch die Differenzfrequenz meist unter 100Hz liegt und im Audiofilter der stationären Empfangsgeräte ausgefiltert wird. Herkömmlich wird in Flugfunkanlagen die gleichzeitige Aussendung von zwei oder mehreren Signalen auf dem selben Kanal nicht detektiert.

Der Erfindung liegt die Aufgabe zu Grunde, ein Verfahren und eine Vorrichtung zu schaffen, mit welcher die Doppeloder Mehrfach-Aussendung von amplitudenmodulierten Signalen eng benachbarter Trägerfrequenz zuverlässig, in kurzer Zeit und mit geringem Aufwand und damit mit geringen Kosten detektierbar ist.

Die Aufgabe wird erfindungsgemäß für das Verfahren durch die Merkmale des unabhängigen Anspruchs 1 und durch die Merkmale des unabhängigen Anspruchs 9 für die Vorrichtung gelöst. Vorteilhafte Weiterbildungen sind Gegenstand der hierauf rückbezogenen Unteransprüche.

Zur Detektion des Vorhandenseins mehrerer amplitudenmodulierter Hochfrequenzsignale in einem Summensignal bei eng benachbarten Trägerfrequenzen wird das Summensignal von einem Phasendemodulator phasendemoduliert und von einer Transformations-Einrichtung in den Frequenzraum z.B. durch Fouriertransformation oder Wavelet-Transformation transformiert. Anhand der Transformation wird durch eine Auswertungs-Einrichtung das Vorhandensein mehrerer Trägerfrequenzen bestimmt. Aus dem Vorhandensein mehrerer Trägerfrequenzen kann direkt das Vorhandensein mehrerer Signale ermittelt werden.

Vorteilhafterweise ist das Summensignal ein auf eine Zwischenfrequenz gemischtes Empfangssignal. Durch die Heruntermischung wird eine Reduktion der Anforderungen an die Verarbeitungseinrichtungen auf Grund der verringerten Frequenz des Summensignals erreicht.

Bevorzugt wird das Vorhandensein von zwei amplitudenmodulierten Hochfrequenzsignalen in dem Summensignal detektiert. Durch die Beschränkung auf zwei Signale wird die Detektionssicherheit deutlich verbessert.

Vorteilhafterweise wird bei der Bestimmung des Vorhandenseins mehrerer Trägerfrequenzen in dem Summensignal der Trägerfrequenzversatz bestimmt. Durch die Bestimmung des Trägerfrequenzversatzes kann ein zusätzliches Konfidenzmaß der detektierten Signale auf Grund der unterschiedlichen Wahrscheinlichkeiten der verschiedenen Versatzfrequenzen ermittelt werden.

Die Fouriertransformation wird bevorzugt gleichzeitig mit mehreren unterschiedlichen Transformationsfensterlängen durchführt. So kann für unterschiedliche Trägerfrequenzversätze eine optimale Detektion erreicht werden.

Vorteilhafterweise wird das Vorhandensein mehrerer Trägerfrequenzen in dem Summensignal durch ODER-Verknüpfung der Ergebnisse der gleichzeitigen Fouriertransformationen unterschiedlicher Transformationsfensterlängen detektiert. So wird eine hohe Zuverlässigkeit der Detektion erreicht.

Bevorzugt werden mehrere Fouriertransformationen gleicher Transformationsfensterlänge von zeitlich nacheinander liegenden Signalabschnitten durchführt und damit die Sicherheit des Ergebnisses der Fouriertransformation durch Korrelierung der Ergebnisse der mehreren Fouriertransformationen gleicher Transformationsfensterlänge verbessert. Bei Transformationsfensterlängen, welche unterhalb der zulässigen Verarbeitungszeit liegen, erhöht die Hintereinanderschaltung mehrerer Fouriertransformationen gleicher Fensterlänge die Sicherheit der Detektion.

Vorteilhafterweise wird das Vorhandensein mehrerer Trägerfrequenzen in dem Summensignal durch die Beaufschlagung des Summensignals mit einem Pilotton durch einen Pilottongenerator angezeigt. Der Pilotton ist im hörbaren Bereich angeordnet, und so von dem Bedienpersonal gut wahrnehmbar. Alternativ ist eine optische Anzeige denkbar. So wird eine Detektion zuverlässig angezeigt.

Nachfolgend wird die Erfindung anhand der Zeichnung, in der ein vorteilhaftes Ausführungsbeispiel der Erfindung dargestellt ist, beispielhaft beschrieben. In der Zeichnung zeigen:
- Fig. 1: den Empfang von mehreren Signalen durch eine beispielhafte Empfangsanlage;
- Fig. 2: ein beispielhaftes Spektrum mit zwei amplitudenmodulierten Signalen mit jeweils einem Trägersignal;
- Fig. 3: ein I/Q-Diagramm eines beispielhaften idealen amplitudenmodulierten Signals;
- Fig. 4: ein I/Q-Diagramm eines beispielhaften amplitudenmodulierten Störsignals;
- Fig. 5: ein I/Q-Diagramm eines beispielhaften amplitudenmodulierten Signals mit durch einen Sende-Synthesizer verursachtem überlagertem Phasenrauschen;
- Fig. 6: ein I/Q-Diagramm eines beispielhaften amplitudenmodulierten Signals mit durch eine Sendeendstufe verursachter überlagerter Phasenverzerrung;
- Fig. 7: ein I/Q-Diagramm eines beispielhaften nichtidealen amplitudenmodulierten Signals;
- Fig. 8: ein I/Q-Diagramm eines beispielhaften amplitudenmodulierten Signals mit schematischer Darstellung eines zweiten überlagerten amplitudenmodulierten Signals;
- Fig. 9: ein I/Q-Diagramm eines beispielhaften amplitudenmodulierten Signals mit einem überlagerten zweiten amplitudenmodulierten Signal;
- Fig. 10: ein Spektrum eines beispielhaften amplitudenmodulierten Sprachsignals mit einem überlagerten zweiten nicht modulierten Signal zu zwei unterschiedlichen Zeitpunkten;
- Fig. 11: den Zeitverlauf eines beispielhaften idealen amplitudenmodulierten Sinussignals mit einem teilweise überlagerten zweiten idealen amplitudenmodulierten Sinussignal;
- Fig. 12: den Zeitverlauf des phasendemodulierten Signals aus Fig. 11, und
- Fig. 13: ein beispielhaftes Ausführungsbeispiel der erfindungsgemäßen Vorrichtung.

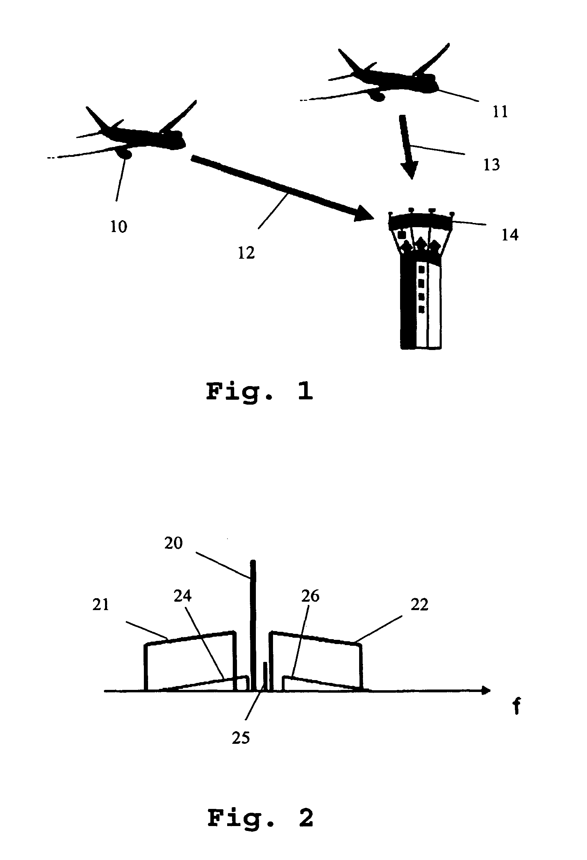

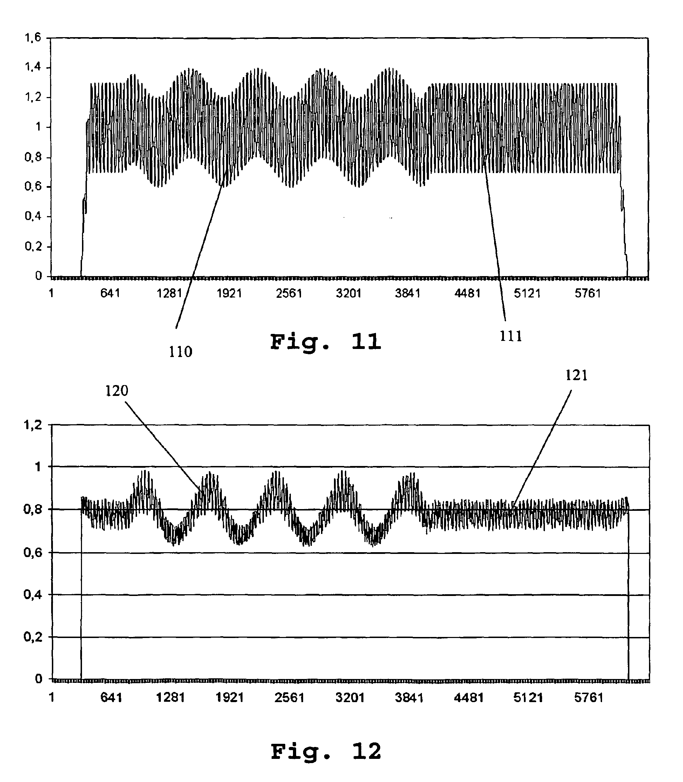

Zunächst wird anhand der Fig. 1 - 10 das der Erfindung zugrundeliegende Signal in seiner Entstehung und Zusammensetzung erläutert, bevor mittels Fig. 11 - 13 die Funktionsweise eines Ausführungsbeispiels des erfindungsgemäßen Verfahrens und der Aufbau eines Ausführungsbeispiels der erfindungsgemäßen Vorrichtung erläutert wird. Identische Elemente wurden in ähnlichen Abbildungen zum Teil nicht wiederholt dargestellt und beschrieben.

Fig. 1 zeigt den Empfang von mehreren Signalen durch eine beispielhafte Empfangsanlage 14. Das Luftfahrzeug 11 sendet aus geringer Entfernung 13 ein Signal an die Bodenstation 14. Das Luftfahrzeug 10 sendet aus größerer Entfernung das Signal 12 an die Bodenstation. Bei identischer Ausgangsleistung der Signale 12 und 13 ergibt sich ein deutlicher Unterschied in der von der Bodenstation empfangenen Leistung der Signale 12 und 13.

In Fig. 2 wird ein beispielhaftes Spektrum mit zwei amplitudenmodulierten Signalen mit jeweils einem Trägersignal 20 und 25 dargestellt. Das stärkere Signal 13 verfügt im Spektrum über eine höhere Amplitude als das schwächere Signal 12. So sind der Träger 20 und die Seitenbänder 21 und 22 in ihrer Amplitude deutlich größer als der Träger 25 und die Seitenbänder 24 und 26. Deutlich sichtbar ist der Trägerfrequenzversatz der beiden Träger 20 und 25, obwohl beide Signale auf dem gleichen Kanal übertragen werden.

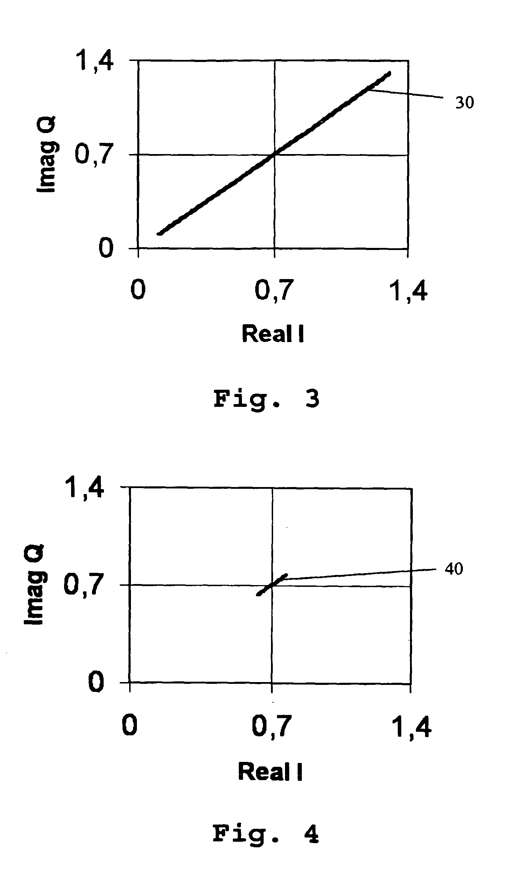

Fig. 3 zeigt ein I/Q-Diagramm eines beispielhaften idealen amplitudenmodulierten Signals. Sprachsignale haben einen mittleren Modulationsgrad von etwa 30% und Spitzen von bis zu 95%, welche vor allem durch Zischlaute verursacht werden. Das Sprachsignal finden sich immer wieder Pausen ohne Aktivität, also eine Dauerträger-Periode (CW, continous wave) mit 0% Modulation. Das Signal 30 weist stets den gleichen Wert der Inphase-Komponente und der Quadratur-Komponente auf.

In Fig. 4 wird ein I/Q-Diagramm eines beispielhaften amplitudenmodulierten Störsignals dargestellt. Besonders kritisch sind niederfrequente Motoren- oder Brummgeräusche, welche periodisch im Sendesignal enthalten sind. Üblicherweise liegen diese etwa 15dB bis 40dB unter dem Nutzsignal und generieren eine Restmodulation von beispielsweise 10%. Das Signal 40 ist ein solches Signal. Auch hier ist weist das Signal stets den gleichen Wert der Inphase-Komponente und der Quadratur-Komponente auf.

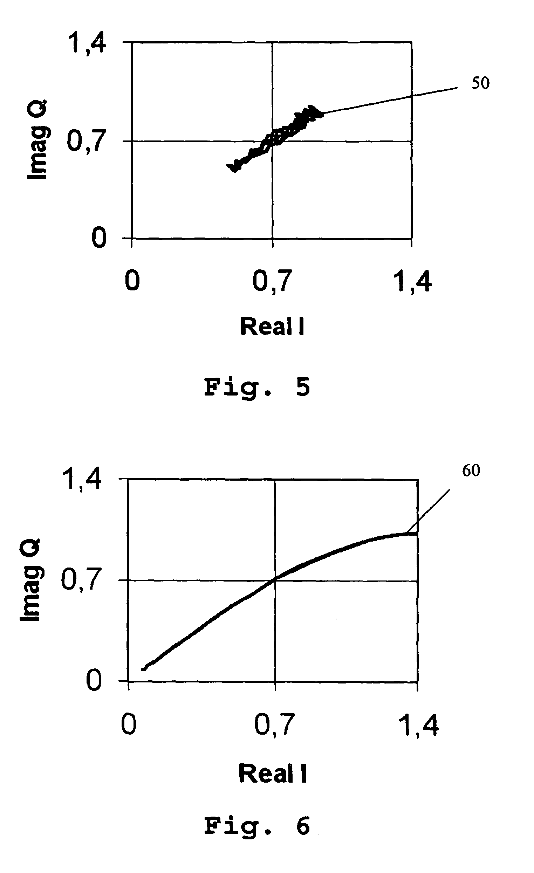

Fig. 5 zeigt ein I/Q-Diagramm eines beispielhaften amplitudenmodulierten Signals mit durch Sende-Synthesizer verursachtem überlagertem Phasenrauschen. Herkömmliche PLL Synthesizer weisen ein starkes Phasenrauschen nahe des Trägers im Bereich unterhalb 100Hz auf. Das Modulationsverfahren AM-DSB ist zwar grundsätzlich unempfindlich gegenüber diesem Phänomen, allerdings wird dadurch das Erkennen des Sekundärsignales erschwert. Gezeigt wird ein AM Signal 50 mit 30% Modulationsgrad unter Berücksichtigung von Phasenrauschen. Damit sind die Inphase-Komponente und die Quadratur-Komponente des Signals 50 nicht mehr stets identisch. In modernen Flugfunkgeräten, welche VDL Mode 2 tauglich sind, kommen phasenstarre DDS oder Fraktional-N Synthesizer zum Einsatz, wonach dieses Problem hier nicht besteht. Allerdings kann man nicht davon ausgehen, dass alle Sprachfunkgeräte diese Technologie beinhalten.

In Fig. 6 wird ein I/Q-Diagramm eines beispielhaften amplitudenmodulierten Signals mit durch eine Sendeendstufe verursachter überlagerter Phasenverzerrung dargestellt. Durch die Nichtlinearität der Sendeendstufe entstehen Phasenschwankungen von mehreren Grad, im Extremfall sogar bis zu +/- 10 Grad, je nach Qualität des Senders. Gezeigt wird, wie ein ideales AM Signal 60 durch den Effekt der synchronen Phasenmodulation beeinflusst wird. So ist ein deutliches Einbrechen des Imaginärteils bei höheren Amplituden festzustellen. Ähnlich wie zuvor sind moderne VDL Mode 2 taugliche Flugfunkgeräte im Vorteil. Durch die aktive Linearisierung werden diese Effekte ausgeglichen, wonach ein solcher Sender auch im AM-DSB Betrieb keine oder nur geringe synchrone PM aufweist.

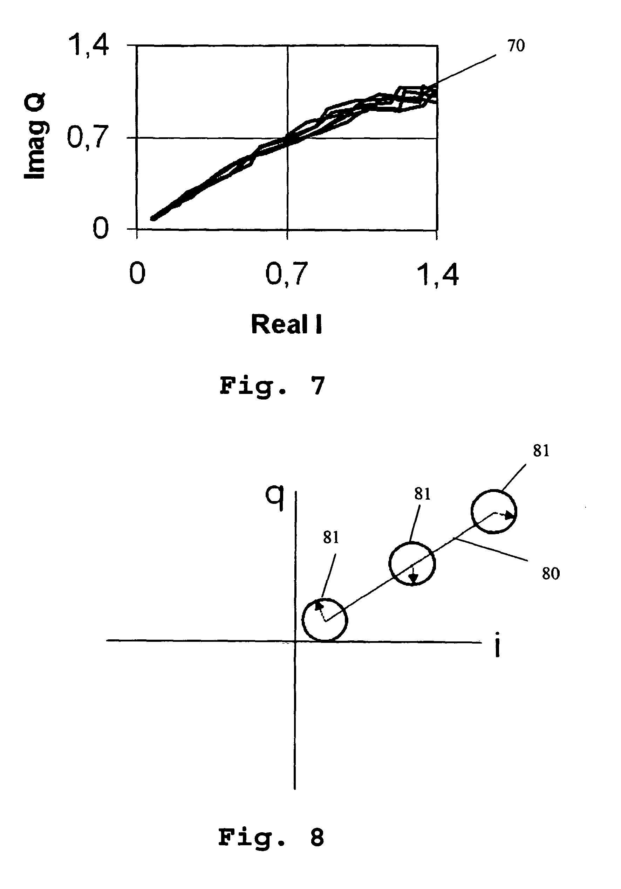

Fig. 7 zeigt ein I/Q-Diagramm eines beispielhaften nichtidealen amplitudenmodulierten Signals. In dieser Figur wird die Überlagerung der anhand der Fig. 3 - 6 gezeigten Signale 30, 40, 50 und 60 dargestellt. Sowohl das Phasenrauschen als auch die synchrone Phasenmodulation, welche dem idealen Signal überlagert sind, sind deutlich sichtbar. Das Störsignal 40 ist auf Grund seiner Ähnlichkeit zu dem idealen Signal 30 nicht erkennbar.

In Fig. 8 wird ein I/Q-Diagramm eines beispielhaften amplitudenmodulierten Signals mit schematischer Darstellung eines zweiten überlagerten amplitudenmodulierten Signals dargestellt. Der Sekundärträger 81 erscheint als SSB-Signal mit einer Differenzfrequenz entsprechend der relativen Quarzablage beider Flugfunksender, also der Frequenzdifferenz zwischen primärem 80 und sekundärem Träger 81.

Würden beide Sendesignale unmoduliert auftreten, was während einer Sprechpause der Fall ist, so hätte man den klassischen Fall einer SSB (Single Side-Band) Modulation. Diese Betrachtung ist auch dann gültig, wenn das Sekundärsignal mit Sprache moduliert wird, da die AM-Seitenbänder des Sekundärsignales im Vergleich zum eigenen Träger 81 vernachlässigbar sind. Somit rotiert der sekundäre Träger 81 mit der Differenzfrequenz um den primären Träger 80. Je nach aktuellem Wert des Primärsignals ergibt sich somit ein Summensignal des primären Signals und des sekundären Trägers.

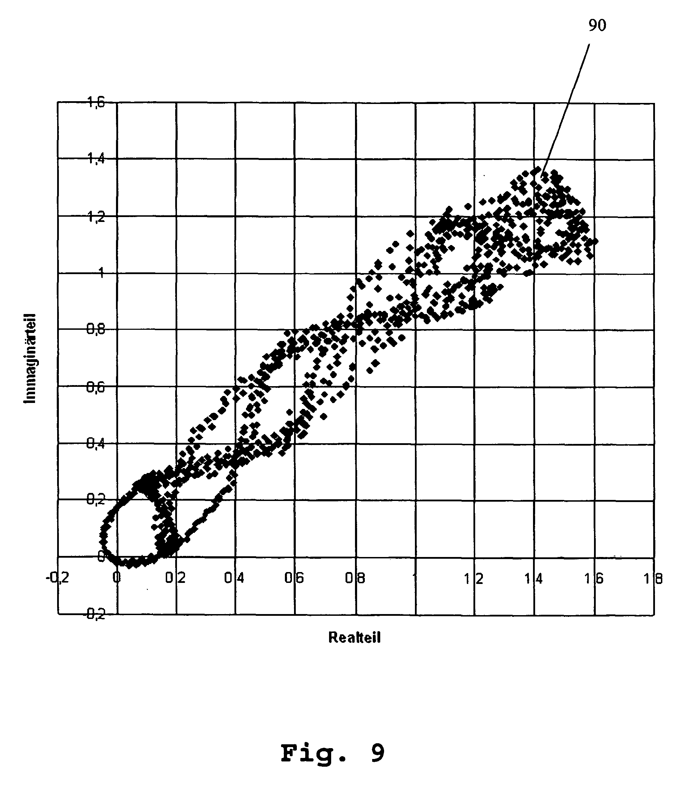

Fig. 9 zeigt ein I/Q-Diagramm eines beispielhaften amplitudenmodulierten Signals mit einem überlagerten zweiten amplitudenmodulierten Signal. Aus den anhand von Fig. 8 dargestellten Überlegungen heraus ergibt sich das in Fig. 9 dargestellte Summensignal 90 im I/Q Diagramm. Die Rotationsbewegung des Sekundärträgers 81 um den Primärträger 80 ist hier deutlich zu erkennen.

Sicherheit und Zuverlässigkeit der Erkennung von Doppelaussendung sind bei reiner AM-Demodulation mit anschließender spektraler Analyse eingeschränkt. Folgendes Beispiel demonstriert das Ergebnis zweier aufeinander folgender Fourier Analysen unter folgenden Bedingungen:
- Primärsignal, moduliert mit Sprache
- Sekundärsignal unmoduliert, Verhältnis zu Primärträger - 20dBC
- Frequenzdifferenz 1khz (kein praktischer Fall)

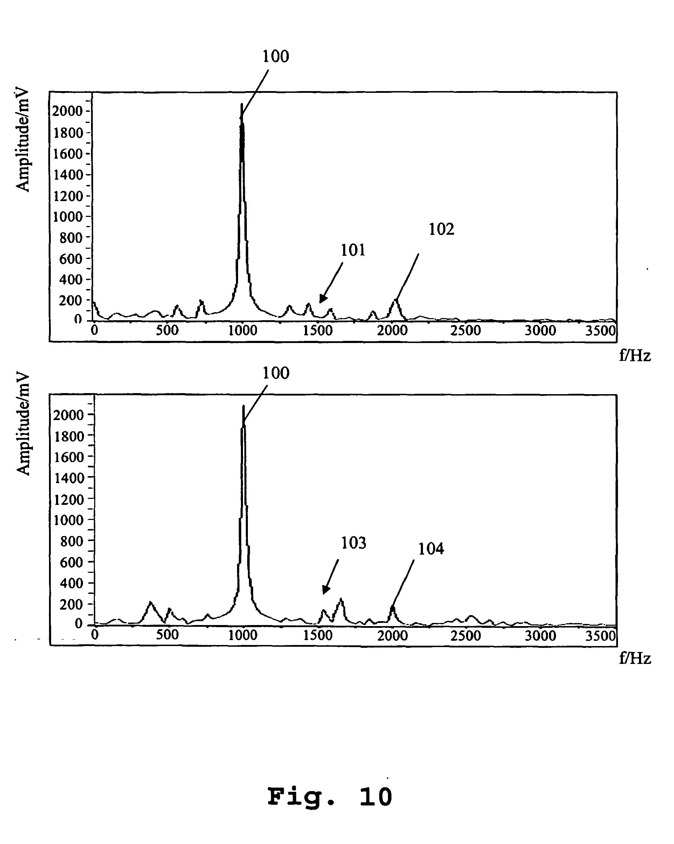

In Fig. 10 wird ein Spektrum eines beispielhaften amplitudenmodulierten Sprachsignals mit einem überlagerten zweiten nicht modulierten Signal zu zwei unterschiedlichen Zeitpunkten dargestellt. Der Sekundärträger 102, 104 im Abstand von 1 kHz liegt um Faktor 10 unter dem Niveau des Primärträgers 100 und geht im Sprachsignal unter. In aufeinander folgenden Auswertungen erkennt man, dass die beiden Trägersignale 102, 104 unverändert existieren, während die beiden zueinander symmetrischen Seitenbänder 101, 103 ihre Energieverteilung gemäß der Sprache ändern. In der Praxis müssen Frequenzablagen zwischen 10Hz und 240Hz erkannt werden, weshalb die FFT - Fensterlänge mindestens 200ms lang sein muss. Der periodisch vorhandene SSB Träger kann durch Kaskadieren mehrerer FFT-Fenster von der Sprache unterschieden werden, was jedoch eine lange Analysezeit erfordert. Ein weiterer Nachteil dieses Verfahrens ist die schlechte Robustheit gegenüber monotonen Nebengeräuschen wie zum Beispiel Motorenlärm mit 200Hz.

Fig. 11 zeigt den Zeitverlauf eines beispielhaften idealen amplitudenmodulierten Sinussignals 111 mit einem teilweise überlagerten zweiten idealen amplitudenmodulierten Sinussignal 110. Die Änderung der Hüllkurve im Bereich des zweiten überlagerten Signals 110 ist deutlich sichtbar. In einer direkten Fouriertransformation ist jedoch das Modulationssignal dominierend.

Wird jedoch anstelle des AM Demodulationssignals das in der Phase demodulierte Signal ausgewertet, ergibt sich eine vielfach verbesserte Signifikanz. In Fig. 12 wird der Zeitverlauf des phasendemodulierten Signals aus Fig. 11 dargestellt. Das Beispiel zeigt, dass das ursprünglich dominante Modulationssignal 121 selbst bei einem herkömmlichen Sender mit synchroner Phasenmodulation stark gedämpft am Ausgang des Phasendemodulators in Erscheinung tritt. Das gesuchte SSB Sekundärsignal 120 hingegen wird durch die Phasendemodulation hervorgehoben. Wenn man dieses Signal nun fouriertransformiert, wird das Differenzsignal als Hauptkomponente ersichtlich.

Wegen der geforderten Feinauflösung von 10Hz oder weniger muss die Fenstergröße für die Fouriertransformation bzw. Fast Fouriertransformation sehr lange gewählt werden und 200ms oder mehr betragen. Im Hinblick auf eine brauchbare Reaktionszeit des Algorithmus können nur zwei, maximal drei Fenster ausgewertet werden, was allerdings auf Kosten der Detektionssicherheit geht. Mittels adaptiver Fensterung oder durch Anwendung von Wavelets kann zu jeder Differenzfrequenz immer die optimale Auflösung gewählt werden. In den meisten Fällen können mehrere Auswertefenster aneinandergereiht ausgewertet und zueinander korreliert werden, wonach der periodische SSB Träger des Sekundärsignales zuverlässig detektiert werden kann.

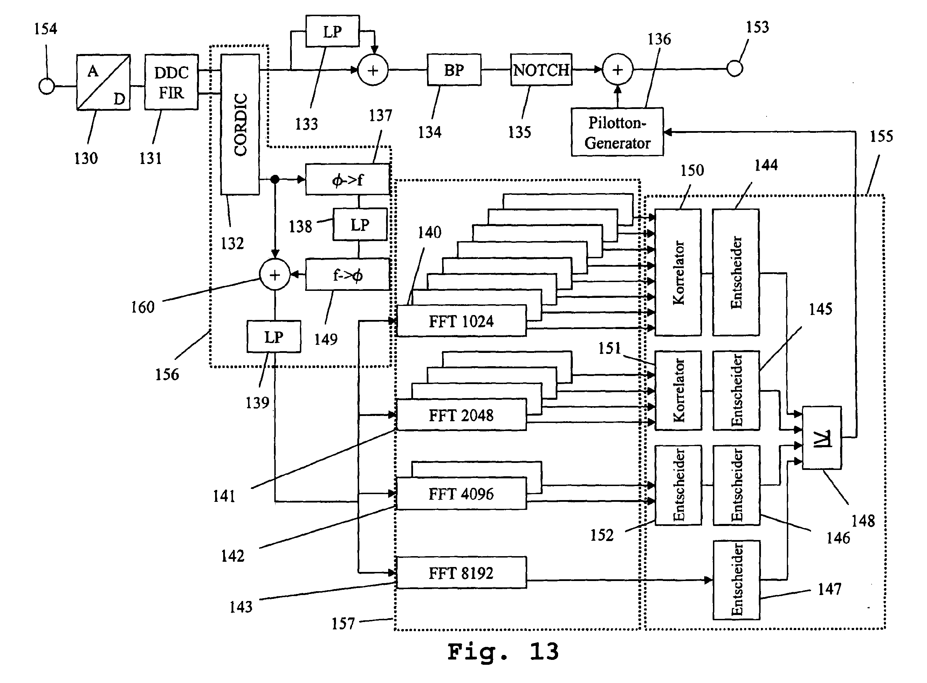

Fig. 13 zeigt ein beispielhaftes Ausführungsbeispiel der erfindungsgemäßen Vorrichtung. Das Zwischenfrequenzsignal, welches an dem Eingang 154 anliegt, wird einem Analog-Digital-Wandler 130 zugeführt und von diesem quantisiert und abgetastet. Ein nachgeschaltetes DDC FIR (finite impulse response) Filter 131 erzeugt aus dem digitalisierten Signal eine Inphase- und eine Quadratur-Komponente. Der CORDIC Baustein 132 erzeugt hieraus eine Betrags- und eine Phasen-Komponente. Die Betragskomponente wird nach einer Offsetkorrektur mittels eines Tiefpasses 133 über einen Bandpass 134 und einen Notch-Filter 135 an den Audio-Ausgang 153 geleitet. Der Bandpass 134 und der Notch-Filter 135 entfernen dabei ungewünschte Signalanteile.

Die Phasen-Komponente des Signals wird über zwei Pfade an einen einem Tiefpass 139 vorgeschalteten Addierer 160 geleitet. Der eine Pfad ist eine direkte Verbindung. Auf dem zweiten Pfad wird das Phasensignal zunächst in dem Block 137 in ein Frequenzsignal gewandelt. Mittels des Tiefpasses 138 werden hochfrequente Anteile entfernt. Anschließend wird das Signal in Block 149 zurück in ein Phasensignal gewandelt und mit dem unmodifizierten Signal summiert. Dieser Schritt dient dem Frequenztracking. Der Tiefpass 139 reduziert die Phasenschwankungen um hochfrequente Anteile. Die Blöcke 132, 137, 138, 149 und 139 bilden dabei den Phasendemodulator 156.

Das Signal wird nun durch mehrere FFT Bänke 140, 141, 142 und 143 bearbeitet, indem eine schnelle Fourier Transformation (FFT, Fast Fourier Transformation) durchgeführt wird. Bei einer Verarbeitungszeit von z.B. 256 ms wird der Signalabschnitt in der FFT Bank 143 von einem einzelnen FFT Fenster von z.B. 8192 Bit Länge verarbeitet. Die FFT Bänke 140, 141 und 142 verfügen über eine geringere Fensterlänge und damit über eine kürzere Verarbeitungszeit. Somit wird der Signalabschnitt von mehreren FFT Fenstern geringerer Fensterlänge verarbeitet. Die Blöcke 140, 141, 142 und 143 bilden dabei die Fourier-Transformations-Einrichtung 157.

Die Resultate der FFT Bänke 140, 141 und 142 werden von Korrelatoren 150, 151 und 152 korreliert und damit in ihrer Aussagekraft verstärkt. Die Entscheider 144, 145, 146 und 147 beurteilen, ob durch die FFT der einzelnen Fensterlängen ausreichend signifikante Anteile der in der Phasendemodulation entstandenen Differenzfrequenzen der Zwischenfrequenzsignale enthalten sind. Ist dies der Fall, wird der Wert 1 an die ODER-Verknüpfung 148 weitergegeben. Die Blöcke 150, 151, 152, 144, 145, 146, 147 und 148 bilden dabei die Auswertungs-Einrichtung 155. Ergibt die ODER-Verknüpfung 148 den Wert 1, so wird der Pilottongenerator 136 aktiviert, und dem Audio-Aufgang 153 zusätzlich ein deutlich hörbarer Pilotton zugeführt.

Die Erfindung ist nicht auf das dargestellte Ausführungsbeispiel beschränkt. So können unterschiedliche Transformationsfunktionen an Stelle der Fouriertransformation , wie z.B. die FFT, Wavelets, oder ähnliche Transformationen in den Frequenzraum genutzt werden. Anstelle eines akustischen Warnsignals kann auch ein optisches Warnsignal ausgegeben werden. Alle vorstehend beschriebenen Merkmale oder in den Figuren gezeigten Merkmale sind im Rahmen der Erfindung beliebig miteinander kombinierbar.

## Patentansprüche

1. Verfahren zur Detektion des Vorhandenseins mehrerer amplitudenmodulierter Hochfrequenzsignale mit überlagerter Phasenverzerrung in einem Summensignal bei eng benachbarten Trägerfrequenzen (20, 25) der amplitudenmodulierten Hochfrequenzsignale, wobei die folgenden Schritte durchgeführt werden:
- Phasendemodulation des Summensignals,
- Transformation des phasendemodulierten Summensignals in den Frequenzraum, und
- Bestimmung des Vorhandenseins mehrerer Trägerfrequenzen (20, 25) amplitudenmodulierter Hochfrequenzsignale.

2. Verfahren nach Anspruch 1,
**dadurch gekennzeichnet,**
**dass** das Summensignal ein auf eine Zwischenfrequenz gemischtes Empfangssignal ist.

3. Verfahren nach Anspruch 1 oder 2,
**dadurch gekennzeichnet,**
**dass** das Vorhandensein von zwei amplitudenmodulierten Hochfrequenzsignalen in dem Summensignal detektiert wird.

4. Verfahren nach einem der Ansprüche 1 bis 3,
**dadurch gekennzeichnet,**
**dass** bei der Bestimmung des Vorhandenseins mehrerer Trägerfrequenzen (20, 25) amplitudenmodulierter Hochfrequenzsignale in dem Summensignal der Trägerfrequenzversatz der amplitudenmodulierten Hochfrequenzsignale bestimmt wird.

5. Verfahren nach einem der Ansprüche 1 bis 4,
**dadurch gekennzeichnet,**
**dass** als Transformation in den Frequenzraum eine Fouriertransformation und/oder eine Wavelet-Transformation durchgeführt wird.

6. Verfahren nach Anspruch 5,
**dadurch gekennzeichnet,**
**dass** mehrere Fouriertransformationen gleichzeitig mit mehreren zeitlich unterschiedlichen Transformationsfensterlängen durchgeführt werden.

7. Verfahren nach Anspruch 6,
**dadurch gekennzeichnet,**
**dass** das Vorhandensein mehrerer Trägerfrequenzen (20, 25) in dem Summensignal durch ODER-Verknüpfung der Ergebnisse der gleichzeitigen Fouriertransformationen unterschiedlicher Transformationsfensterlängen detektiert wird.

8. Verfahren nach einem der Ansprüche 5 bis 7,
**dadurch gekennzeichnet,**
**dass** mehrere Fouriertransformationen gleicher Transformationsfensterlänge von zeitlich nacheinander liegenden Signalabschnitten durchgeführt werden, und
**dass** die Sicherheit des Ergebnisses der Fouriertransformationen durch Korrelierung der Ergebnisse der mehreren Fouriertransformationen gleicher Transformationsfensterlänge erhöht wird.

9. Vorrichtung zur Detektion des Vorhandenseins mehrerer amplitudenmodulierter Hochfrequenzsignale mit überlagerter Phasenverzerrung in einem Summensignal bei eng benachbarten Trägerfrequenzen (20, 25) der amplitudenmodulierten Hochfrequenzsignale, mit einem Phasendemodulator (156), einer Transformations-Einrichtung (157) und einer Auswertungseinrichtung (155), wobei der Phasendemodulator (156) das Summensignal nach seiner Phase demoduliert,
wobei die Transformations-Einrichtung (157) das phasendemodulierte Summensignal in den Frequenzraum transformiert, und
wobei die Auswertungseinrichtung (155) das Vorhandensein mehrerer Trägerfrequenzen (20, 25) amplitudenmodulierter Hochfrequenzsignale bestimmt.

10. Vorrichtung nach Anspruch 9,
**dadurch gekennzeichnet,**
**dass** das Summensignal ein auf eine Zwischenfrequenz gemischtes Empfangssignal ist.

11. Vorrichtung nach Anspruch 9 oder 10,
**dadurch gekennzeichnet,**
**dass** die Vorrichtung das Vorhandensein von zwei amplitudenmodulierten Hochfrequenzsignalen in dem Summensignal detektiert.

12. Vorrichtung nach einem der Ansprüche 9 bis 11,
**dadurch gekennzeichnet,**
**dass** bei der Bestimmung des Vorhandenseins mehrerer Trägerfrequenzen (20, 25) amplitudenmodulierter Hochfrequenzsignale in dem Summensignal durch die Auswertungseinrichtung (155) der Trägerfrequenzversatz der amplitudenmodulierten Hochfrequenzsignale bestimmt wird.

13. Vorrichtung nach einem der Ansprüche 9 bis 12,
**dadurch gekennzeichnet,**
**dass** die Transformations-Einrichtung (157) eine Fouriertransformation und/oder eine Wavelet-Transformation durchführt.

14. Vorrichtung nach Anspruch 13,
**dadurch gekennzeichnet,**
**dass** die Transformations-Einrichtung (157) die Fouriertransformation gleichzeitig mit mehreren zeitlich unterschiedlichen Transformationsfensterlängen durchführt.

15. Vorrichtung nach Anspruch 14,
**dadurch gekennzeichnet,**
**dass** das Vorhandensein mehrerer Trägerfrequenzen in dem Summensignal von der Auswertungs-Einrichtung (155) durch ODER-Verknüpfung der Ergebnisse der gleichzeitigen Fouriertransformationen unterschiedlicher Transformationsfensterlängen detektiert wird.

16. Vorrichtung nach einem der Ansprüche 13 bis 15,
**dadurch gekennzeichnet,**
**dass** die Transformations-Einrichtung (157) mehrere Fouriertransformationen gleicher Transformationsfensterlänge von zeitlich nacheinander liegenden Signalabschnitten durchführt, und
**dass** die Sicherheit des Ergebnisses der Fouriertransformation durch Korrelierung der Ergebnisse der mehreren Fouriertransformationen gleicher Transformationsfensterlänge von einem Korrelator (150, 151, 152) in der Auswertungseinrichtung (155) erhöht wird.

17. Vorrichtung nach einem der Ansprüche 9 bis 16,
**dadurch gekennzeichnet,**
**dass** das Vorhandensein mehrerer Trägerfrequenzen in dem Summensignal durch die Beaufschlagung des Summensignals mit einem Pilotton durch einen Pilottongenerator (136) angezeigt wird und/oder dass ein optisches Alarmsignal erzeugt wird.

## Claims

1. Method for detecting the presence of several amplitude-modulated high-frequency signals with superposed phase-distortion in a sum signal with closely-adjacent carrier frequencies (20, 25) of the amplitude-modulated high-frequency signals, wherein the following steps are implemented:
- phase demodulation of the sum signal,
- transformation of the phase-demodulated sum signal into the frequency domain, and determination of the presence of several carrier frequencies (20, 25) of amplitude-modulated high-frequency signals.

2. Method according to claim 1,
**characterised in that**
the sum signal is a received signal mixed to an intermediate frequency.

3. Method according to claim 1 or 2,
**characterised in that**
the presence of two amplitude-modulated high-frequency signals is detected in the sum signal.

4. Method according to any one of claims 1 to 3,
**characterised in that,**
in determining the presence of several carrier frequencies (20, 25) of amplitude-modulated high-frequency signals in the sum signal, the carrier-frequency offset of the amplitude-modulated high-frequency signals is determined.

5. Method according to any one of claims 1 to 4,
**characterised in that,**
as the transformation into the frequency domain, a Fourier transform and/or a wavelet transformation is implemented.

6. Method according to claim 5,
**characterised in that**
several Fourier transforms are implemented simultaneously with several transformation-window lengths different with reference to time.

7. Method according to claim 6,
**characterised in that**
the presence of several carrier frequencies (20, 25) in the sum signal is detected through OR disjunction of the results of the simultaneous Fourier transforms of different transformation-window lengths.

8. Method according to any one of claims 5 to 7,
**characterised in that**
several Fourier transforms of identical transformation-window length of signal portions disposed in time succession are implemented, and that the security of the result of the Fourier transform is increased by correlating the results of the several Fourier transforms of identical transformation-window length.

9. Device for detecting the presence of several amplitude-modulated high-frequency signals with superposed phase-distortion in a sum signal with closely-adjacent carrier frequencies (20, 25) of the amplitude-modulated high-frequency signals, with a phase demodulator (156), a transformation device (157) and an evaluation device (155), wherein the phase demodulator (156) demodulates the sum signal according to its phase,
wherein the transformation device (157) transforms the phase-demodulated sum signal into the frequency domain, and
wherein the evaluation device (155) determines the presence of several carrier frequencies (20, 25) of amplitude-modulated high-frequency signals.

10. Device according to claim 9,
**characterised in that**
the sum signal is a received signal mixed to an intermediate frequency.

11. Device according to claim 9 or 10,
**characterised in that**
the device detects the presence of two amplitude-modulated high-frequency signals in the sum signal.

12. Device according to any one of claims 9 to 11,
**characterised in that,**
in determining the presence of several carrier frequencies (20, 25) of amplitude-modulated high-frequency signals in the sum signal, the carrier-frequency offset of the amplitude-modulated high-frequency signals is determined by the evaluation device (155).

13. Device according to any one of claims 9 to 12,
**characterised in that**
the transformation device (157) implements a Fourier transform and/or a wavelet transformation.

14. Device according to claim 13,
**characterised in that**
the transformation device (157) implements the Fourier transform simultaneously with several transformation-window lengths different with reference to time.

15. Device according to claim 14,
**characterised in that**
the presence of several carrier frequencies in the sum signal is detected by the evaluation device (155) through OR disjunction of the results of the simultaneous Fourier transforms of different transformation-window lengths.

16. Device according to any one of claims 13 to 15,
**characterised in that**
the transformation device (157) implements several Fourier transforms of the same transformation-window length of signal portions disposed in time succession, and
that the security of the results of the Fourier transform is increased by correlating the results of the several Fourier transforms of identical transformation-window length through a correlator (150, 151, 152) in the evaluation device (155).

17. Device according to any one of claims 9 to 16,
**characterised in that**
the presence of several carrier frequencies in the sum signal is displayed by charging the sum signal with a pilot tone through a pilot-tone generator (136) and/or that an optical alarm signal is generated.

## Revendications

1. Procédé de détection de l'existence de plusieurs signaux haute fréquence modulés en amplitude avec une distorsion de phase superposée dans un signal de somme dans le cas de fréquences porteuses très proches (20, 25) des signaux haute fréquence modulés en amplitude, dans lequel les étapes suivantes sont effectuées :
- démodulation de phase du signal de somme,
- transformation du signal de somme démodulé en phase dans le domaine fréquentiel, et
- détermination de l'existence de plusieurs fréquences porteuses (20, 25) de signaux haute fréquence modulés en amplitude.

2. Procédé selon la revendication 1, **caractérisé en ce que**
le signal de somme est un signal de réception mélangé à une fréquence intermédiaire.

3. Procédé selon la revendication 1 ou 2,
**caractérisé en ce que**
l'existence de deux signaux haute fréquence modulés en amplitude est détectée dans le signal de somme.

4. Procédé selon l'une des revendications 1 à 3,
**caractérisé en ce que**
le décalage de fréquences porteuses des signaux haute fréquence modulés en amplitude est déterminé lors de la détermination de l'existence de plusieurs fréquences porteuses (20, 25) de signaux haute fréquence modulés en amplitude dans le signal de somme.

5. Procédé selon l'une des revendications 1 à 4,
**caractérisé en ce que**
une transformation de Fourier et/ou une transformation en ondelettes est effectuée en tant que transformation dans le domaine fréquentiel.

6. Procédé selon la revendication 5, **caractérisé en ce que**
plusieurs transformations de Fourier sont effectuées simultanément avec plusieurs longueurs de fenêtre de transformation temporellement différentes.

7. Procédé selon la revendication 6, **caractérisé en ce que**
l'existence de plusieurs fréquences porteuses (20, 25) dans le signal de somme est détectée par opération logique OU des résultats des transformations de Fourier simultanées de longueurs de fenêtre de transformation différentes.

8. Procédé selon l'une des revendications 5 à 7,
**caractérisé en ce que**
plusieurs transformations de Fourier de longueurs de fenêtre de transformation égales de parties de signaux temporellement consécutifs sont effectuées, et
**en ce que** la sûreté des résultats des transformations de Fourier est augmentée par corrélation des résultats de plusieurs transformations de Fourier de longueurs de fenêtre de transformation égales.

9. Dispositif pour détecter l'existence de plusieurs signaux haute fréquence modulés en amplitude avec une distorsion de phase superposée dans un signal de somme dans le cas de fréquences porteuses très proches (20, 25) de signaux haute fréquence modulés en amplitude, comportant un démodulateur de phase (156), un dispositif de transformation (157) et un dispositif d'évaluation (155),
dans lequel le démodulateur de phase (156) démodule le signal de somme d'après sa phase,
dans lequel le dispositif de transformation (157) transforme le signal de somme démodulé en phase dans le domaine fréquentiel, et
dans lequel le dispositif d'évaluation (155) détermine l'existence de plusieurs fréquences porteuses (20, 25) de signaux haute fréquence modulés en amplitude.

10. Dispositif selon la revendication 9, **caractérisé en ce que**
le signal de somme est un signal de réception mélangé à une fréquence intermédiaire.

11. Dispositif selon la revendication 9 ou 10,
**caractérisé en ce que**
le dispositif détecte l'existence de deux signaux haute fréquence modulés en amplitude dans le signal de somme.

12. Dispositif selon l'une des revendications 9 à 11,
**caractérisé en ce que**
le décalage de fréquences porteuses des signaux haute fréquence modulés en amplitude est déterminé lors de la détermination de l'existence de plusieurs fréquences porteuses (20, 25) de signaux haute fréquence modulés en amplitude dans le signal de somme par le dispositif d'évaluation (155).

13. Dispositif selon l'une des revendications 9 à 12,
**caractérisé en ce que**
le dispositif de transformation (157) effectue une transformation de Fourier et/ou une transformation en ondelettes.

14. Dispositif selon la revendication 13, **caractérisé en ce que**
le dispositif de transformation (157) effectue la transformation de Fourier simultanément avec plusieurs longueurs de fenêtre de transformation différentes dans le temps.

15. Dispositif selon la revendication 14, **caractérisé en ce que**
l'existence de plusieurs fréquences porteuses dans le signal de somme est détectée par le dispositif d'évaluation (155) par opération logique OU des résultats des transformations de Fourier simultanées de longueurs de fenêtre de transformation différentes.

16. Dispositif selon l'une des revendications 13 à 15, **caractérisé en ce que**
le dispositif de transformation (157) effectue plusieurs transformations de Fourier de longueurs de fenêtre de transformation égales de parties de signaux se suivant dans le temps, et
**en ce que** la sûreté des résultats de la transformation de Fourier est augmentée par corrélation des résultats de plusieurs transformations de Fourier de longueurs de fenêtre de transformation égales par un corrélateur (150, 151, 152) dans le dispositif d'évaluation (155).

17. Dispositif selon l'une des revendications 9 à 16,
**caractérisé en ce que**
l'existence de plusieurs fréquences porteuses dans le signal de somme est annoncée par l'alimentation du signal de somme par un son pilote grâce à un générateur de son pilote (136) et/ou **en ce qu'**un signal d'alarme optique est généré.
